# EUROPEAN PATENT APPLICATION

(11) **EP 3 678 462 A1**
(43) Date of publication of application: **08.07.2020**
(21) Application number: 18851970.6
(22) Date of filing: 27.08.2018
(51) Int. Cl.: H05K 7/20, G09F 9/00, H01L 23/36, H01L 23/40

(54) **HEAT DISSIPATION STRUCTURE**

(30) Priority: 30.08.2017 JP 2017165120
(71) Applicant: Nippon Seiki Co., Ltd., Nagaoka-shi, Niigata 940-8580 (JP)
(72) Inventor: IWANAGA Takahiro, Niigata (JP)
(74) Representative: Jackson, Richard Eric
(86) International application number: PCT/JP2018/031479
(87) International publication number: WO 2019/044731

(57) **Abstract**

The present invention provides a heat dissipation structure which suppresses the positional displacement of a heat conduction member and with which it is possible to achieve a preferable heat dissipation function.

The present invention is provided with: a display means 10 that has a display element 11 equipped with a display unit 11a for displaying prescribed information, a light source 12b serving as a heating electronic component for supplying illumination light to the display element 11, and a conductive frame body 16 for housing the display element 11 and the light source 12b; a heat conducting member 30 that transfers heat emitted by the light source 12b from the frame body 16 to a heat dissipation member 40; and a case member 50 that has an enclosure part 51 for enclosing the upper part 41a of the heat dissipation member 40 (heat dissipation part 41), wherein the enclosure part 51 encloses the upper part 41a of the heat dissipation part 41 in such a manner as to come into abutment with a non-contact part 31 of the heat conducting member 30 that is not in contact with the heat dissipation member 40.

## Description

### TECHNICAL FIELD

The present invention relates to a heat dissipation structure for transferring heat emitted by a heating electronic component to a heat dissipation member using a heat conducting member.

### BACKGROUND ART

In related art, a heat dissipation structure applicable to a display device as described in Patent Document 1 below is known, for example, as such a type of heat dissipation structure. The heat dissipation structure used in the display device described in Patent Document 1 includes: a display means including a display element (liquid crystal display element) equipped with a display unit for displaying prescribed information, a light source for supplying illumination light to the display element, and a frame body made of a conductive material and provided with a display window portion to correspond to the display unit, the frame body for housing the display element and the light source; a heat dissipation member capable of dissipating heat emitted by the light source through the frame body; and a heat conducting member sandwiched between the frame body and the heat dissipation member and made of silicon rubber, the heat conducting member for transferring the heat from the frame body to the heat dissipation member.

Here, if attention is paid to the size of the outer shape of the heat conducting member and the heat dissipation member as viewed from a side of a viewer (the front side) viewing the display element (display unit), the outer shapes of the heat conducting member and the heat dissipation member are generally almost matched. According to such a configuration, the heat emitted by the light source is dissipated into the atmosphere by passing through the frame body, the heat conducting member (located on the back side of the frame body), and the heat dissipation member (located on the further back side of the heat conducting member).

### PRIOR ART DOCUMENT

### PATENT DOCUMENT

Patent Document 1: Japanese Unexamined Patent Application Publication No. 2013-170993

### SUMMARY OF THE INVENTION

### PROBLEMS TO BE SOLVED BY THE INVENTION

However, in the heat dissipation structure described in Patent Document 1 above, the heat conducting member is configured to be simply sandwiched between the heat dissipation member and the frame body provided in the display means. That is, the heat conducting member is merely sandwiched between the heat dissipation member and the frame body in an unstable state. For example, when the display device is assembled, the heat conducting member may be sandwiched between the heat dissipation member and the frame body while being positionally displaced. Thus, in such a state where the heat conducting member is positionally displaced, there is a problem that the contact area between the heat conducting member and the heat dissipation member decreases, and thus, a good heat dissipation function cannot be achieved.

Accordingly, it is desirable to provide a heat dissipation structure capable of suppressing positional displacement of the heat conducting member and providing a good heat dissipation function, to cope with the above-described problem.

### SOLUTION TO PROBLEM

A heat dissipation structure of the present invention includes: a heating electronic component; a heat conducting member for transferring heat emitted by the heating electronic component to a heat dissipation member; and a case member including an enclosure part for enclosing at least part of the heat dissipation member The enclosure part encloses the at least part of the heat dissipation member such that the enclosure part abuts against a non-contact part of the heat conducting member not in contact with the heat dissipation member.

Further, a heat dissipation structure of the present invention includes: a display means including a display element equipped with a display unit for displaying prescribed information, a light source serving as a heating electronic component for supplying illumination light to the display element, and a conductive frame body for housing the display element and the light source; a heat conducting member for transferring heat emitted by the light source from the conductive frame body to a heat dissipation member; and a case member including an enclosure part for enclosing at least part of the heat dissipation member. The enclosure part encloses the at least part of the heat dissipation member such that the enclosure part abuts against a non-contact part of the heat conducting member not in contact with the heat dissipation member.

Further, in the heat dissipation structure of the present invention, the enclosure part includes a wall part covering a side of the heat conducting member.

### EFFECT OF THE INVENTION

According to the present invention, it is possible to provide a heat dissipation structure capable of providing achievement of an intended object, suppressing positional displacement of a heat conducting member, and providing a good heat dissipation function.

### BRIEF DESCRIPTION OF THE DRAWINGS

Fig. 1 is a front view of a display device according to a first embodiment of the present invention.
Fig. 2 is a cross-sectional view taken along A-A in Fig. 1.
Fig. 3 is a cross-sectional view of the main parts of a display device according to a second embodiment of the present invention.

### MODE FOR CARRYING OUT THE INVENTION

### First Embodiment

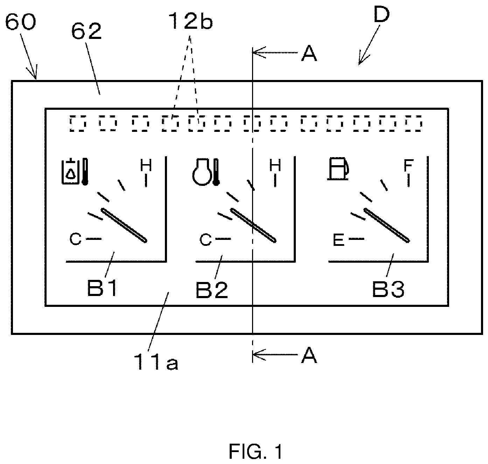

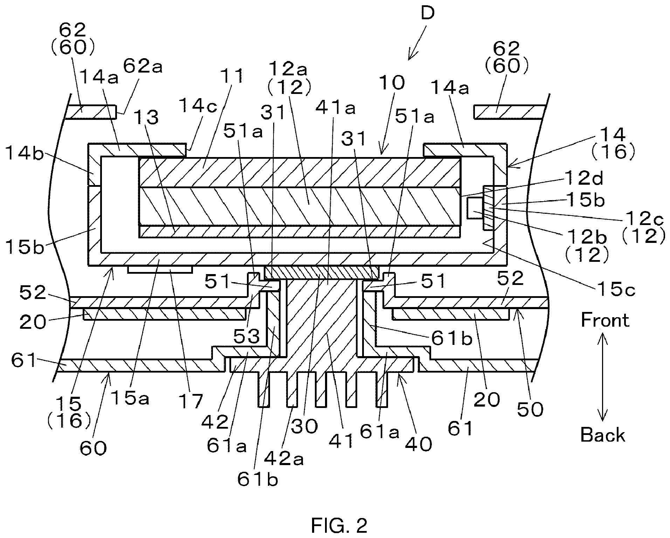

Next, based on Fig. 1 and Fig. 2, a case in which a heat dissipation structure according to the present invention is applied to a display device mounted on a vehicle such as a construction machine will be described as an example. It is noted that in the following description, a side of a viewer viewing the display device is referred to as a front side, and a non-viewer side opposite to the viewer side is referred to as a back side (or a rear side).

In Fig. 1 and Fig. 2, a display device D according to the present embodiment includes: a display means 10; a wiring board 20 located on the back side of the display means 10; a heat conducting member 30 located on the back side of the display means 10 to abut against a below-described rear frame provided in the display means 10; a heat dissipation member 40 being a heat sink located on the back side of the heat conducting member 30; a case member 50 placed on the wiring board 20; and a housing 60 for housing the display means 10, the wiring board 20, the heat conducting member 30, and the case member 50.

The display means 10 includes: a display element 11; a source line driving circuit (not illustrated) for driving a source line (signal line) of the display element 11; a gate line driving circuit (not illustrated) for driving a gate line (scanning line) of the display element 11; an illumination means 12 which includes a light guide body 12a, a light source 12b, a first flexible wiring board 12c, and the like, the illumination means 12 for guiding illumination light to the display element 11; a resin case 13 made of a substantially flat white resin, the resin case 13 for holding the display element 11 and the light guide body 12a; a conductive frame body 16 (made of metal) which includes in an exterior case of the display means 10 and includes a front frame 14 and a rear frame 15; and a circuit board 17 mounted with a timing controller (not illustrated) or the like for generating various timing signals controlling a timing of the source line driving circuit and the gate line driving circuit based on a command signal from a control unit (not illustrated) mounted on the wiring board 20.

In this case, the frame body 16 including the front frame 14 and the rear frame 15 paired with the front frame 14 houses (stores) therein the display element 11, the light guide body 12a, the light source 12b, the resin case 13, and the like, and the circuit board 17 is arranged to abut against a part of a below-described bottom surface portion of the rear frame 15. It is noted that the circuit board 17 is electrically connected to the wiring board 20 using an appropriate conduction means although the detailed illustration of this is omitted.

If necessary, one or more optical members (such as a diffusion sheet or a prism sheet) for substantially uniformly illuminating the display element 11 with backlight may be arranged between the display element 11 and the light guide body 12a.

The display element 11 is, for example, formed of a TFT-based liquid crystal display element having a plurality of pixels, and includes a display unit 11a for displaying vehicle information (prescribed information) such as a hydraulic oil temperature display unit B1 for displaying a hydraulic oil temperature in an oil tank based on detection signals from various sensors mounted on the vehicle, a cooling water temperature display unit B2 for displaying a cooling water temperature of a radiator for cooling an engine which is a drive source of a hydraulic pump, and a fuel residual amount display unit B3 for displaying a residual amount of fuel in a fuel tank. The display unit 11a is displayed in a display area (not illustrated) of the display element 11.

The light guide body 12a is made of a substantially flat translucent synthetic resin and is arranged along the rear surface of the display element 11. In other words, the light guide body 12a is arranged in the illumination optical path from the light source 12b to the display element 11.

The light source 12b serving as a heating electronic component includes a chip-type light emitting diode emitting an appropriate color, and includes a plurality of light emitting bodies for supplying illumination light to the display element 11, and the light emitting bodies are arranged in a row along one side surface 12d located at the upper side of the light guide body 12a, in Fig. 2.

The front frame 14 is made of a conductive material and is press-molded in a substantially frame shape, and has a configuration where a front surface 14a forming the main portion of the front frame 14, and a first peripheral wall part 14b formed to hang downward from the periphery of the front surface 14a are integrally formed. Approximately at the center of the front surface 14a, a display window portion 14c formed of a substantially rectangular opening window is formed to correspond to the display unit 11a.

The rear frame 15 is made of a conductive material similarly to the front frame 14 and is formed in a substantially concave shape in cross section, and has a configuration where a bottom surface 15a forming the main portion of the rear frame 15, and a second peripheral wall part 15b formed to project toward the first peripheral wall part 14b from the periphery of the bottom surface 15a are integrally formed.

In Fig. 2, a first flexible wiring board 12c is fixed to the upper side of the inner wall surface 15c of the second peripheral wall part 15b using an appropriate fixing means, and each light source 12b is mounted on a conductive path (not illustrated) provided in the first flexible wiring board 12c to face one side surface 12d of the light guide body 12a.

The wiring board 20 is formed of a hard circuit board having, for example, a wiring pattern (not illustrated) on the front and back surfaces of a glass epoxy base material, and for example, the control unit, which is a microcomputer that outputs the command signal for a display operation of the display element 11 and another command signal for a lighting operation of the light source 12b, and circuit components (not illustrated) such as resistors and capacitors are conductively connected to the wiring pattern.

The heat conducting member 30 is, for example, formed of silicon rubber having a predetermined thickness, and the outer shape thereof is rectangular. The heat conducting member 30 is provided to contact with both a part of the bottom surface 15a of the rear frame 15 and a below-described heat dissipation part of the heat dissipation member 40, and is provided with the purpose of satisfactorily transferring heat emitted by the light source 12b when the light source 12b is turned on, from the rear frame 15 (frame body 16) to the heat dissipation member 40.

It is noted that in this case, the heat conducting member 30 has a slightly larger outer shape than that of the heat dissipation part and includes a non-contact part 31 which is not in contact with the heat dissipation part. Specifically, the non-contact part 31 here corresponds to the peripheral edge portion on the back side of the heat conducting member 30.

The heat dissipation member 40 is made of a metallic material having a high thermal conductivity such as aluminum, and includes a substantially column-shaped heat dissipation part 41 of which the main portion is housed (embedded) in a below-described frame-shaped part of the housing 60; and a flat plate part 42 formed in a substantially flat plate shape on the back side of the heat dissipation part 41, and has a configuration where a plurality of fins 42a are formed to protrude on the back side of the flat plate part 42.

In other words, here, the heat dissipation member 40 is configured to abut against the back side of the heat conducting member 30 to dissipate (radiate) the heat transferred from the rear frame 15 to the heat conducting member 30 toward the outside of the device (outside of the display device D) in the atmosphere.

The case member 50 is made of, for example, a black synthetic resin material having a light-shielding property, and includes a substantially frame-shaped enclosure part 51 for enclosing an upper part 41a of the heat dissipation part 41 (heat dissipation member 40) on the front side, a horizontal wall part 52 which is formed one level below the position where the enclosure part 51 is formed and extends around the enclosure part 51, and a substantially upright wall-shaped connecting wall part 53 for connecting the enclosure part 51 and the horizontal wall part 52.

Here, the enclosure part 51 is configured to enclose the upper part 41a of the heat dissipation part 41 (heat dissipation member 40) which is at least part of the heat dissipation member 40 such that the enclosure part 51 abuts against the non-contact part 31 of the heat conducting member 30 not in contact with the heat dissipation part 41. Also, the enclosure part 51 includes a wall part 51a having a substantially upright wall shape covering the side of the heat conducting member 30. The wall part 51a has a substantially frame shape along an outer edge portion of the enclosure part 51, and is formed to protrude toward the bottom surface 15a to have a height at which the wall part 51a does not contact with the bottom surface 15a of the rear frame 15.

The housing 60 is a resin case made of, for example, a synthetic resin material, and is included in the exterior case of the display device D. Here, out of components included in the display device D, only the heat dissipation member 40 is exposed to the outside of the housing 60, and the display means 10, the wiring board 20, the heat conducting member 30, and the case member 50 other than the heat dissipation member 40 are housed inside the housing 60.

The housing 60 includes a bottom wall part 61 covering the back side of the wiring board 20 and the case member 50, a side wall part (not illustrated) covering the side of the display means 10, and a front wall part 62 located on the front side of the display means 10. The bottom wall part 61 includes a concave part 61a for housing the flat plate part 42; and a frame-shaped part 61b having a substantially upright wall shape surrounding the heat dissipation part 41 (that is, the heat dissipation part 41 excluding the upper part 41a), and the heat dissipation part 41 is embedded in the internal space of the frame-shaped part 61b.

Furthermore, the frame-shaped part 61b is open on the back side, and on the front side, the frame-shaped part 61b abuts against the back surface of the enclosure part 51. As a result, a configuration is provided in which the enclosure part 51 and the non-contact part 31 of the heat conducting member 30 are sandwiched between the bottom surface 15a and the frame-shaped part 61b. If attention is paid to the three parts, namely the bottom surface 15a, the non-contact part 31, and the enclosure part 51, it can be said that a configuration is provided in which the non-contact part 31 is sandwiched between the bottom surface 15a and the enclosure part 51, and if attention is paid to the three parts, namely the non-contact part 31, the enclosure part 51, and the frame-shaped part 61b, it can be said that a configuration is provided in which the enclosure part 51 is sandwiched between the non-contact part 31 and the frame-shaped part 61b. The front wall part 62 has an opening part 62a that exposes the display unit 11a.

The display device D includes the above components. In such a configuration, if the command signal for a display operation of the display element 11 and the other command signal for a lighting operation of the light source 12b are output from the control unit, while the vehicle information is displayed on the display unit 11a of the display element 11, the vehicle information is illuminated by backlight after the light source 12b is turned on.

The heat emitted by the light source 12b when the light source 12b is turned on is radiated (dissipated) into the atmosphere through the rear frame 15, the heat conducting member 30, and the heat dissipation member 40 (the heat dissipation part 41 and the fins 42a).

At this time, since the non-contact part 31 of the heat conducting member 30 is sandwiched between the bottom surface 15a and the enclosure part 51 (that is, the non-contact part 31 is supported from the back side by the enclosure part 51), the heat conducting member 30 can be prevented from being positionally displaced in the left-right direction (that is, in the plate surface direction of the bottom surface 15a or in the plate surface direction of the wiring board 20) in Fig. 2.

Furthermore, since the wall part 51a is provided in the outer edge portion of the enclosure part 51 to cover the side of the heat conducting member 30, it is advantageous that the positional displacement in the left-right direction of the heat conducting member 30 can be suppressed more reliably.

Therefore, in a state where the positional displacement in the left-right direction of the heat conducting member 30 is thus suppressed, a sufficient contact area is secured between the heat conducting member 30 and the heat dissipation member 40 (heat dissipation part 41), and thus it is possible to provide a heat dissipation structure capable of providing a good heat dissipation function.

As described above, in the present embodiment, the heat conducting member 30 for transferring the heat emitted by the light source 12b from the rear frame 15 (frame body 16) to the heat dissipation member 40, and the case member 50 including the enclosure part 51 for enclosing the upper part 41a of the heat dissipation part 41 which is at least part of the heat dissipation member 40 are provided, and the enclosure part 51 encloses the upper part 41a of the heat dissipation part 41 such that the enclosure part 51 abuts against the non-contact part 31 of the heat conducting member 30 not in contact with the heat dissipation member 40.

Therefore, the positional displacement (in the left-right direction) of the heat conducting member 30 is suppressed since the non-contact part 31 is sandwiched between the bottom surface 15a of the rear frame 15 and the enclosure part 51, and thus, it is possible to provide a heat dissipation structure capable of providing a good heat dissipation function. Moreover, since the non-contact part 31 (heat conducting member 30) is supported from the back side by the enclosure part 51, it is also advantageous that falling of the heat conducting member 30 can be prevented.

### Second Embodiment

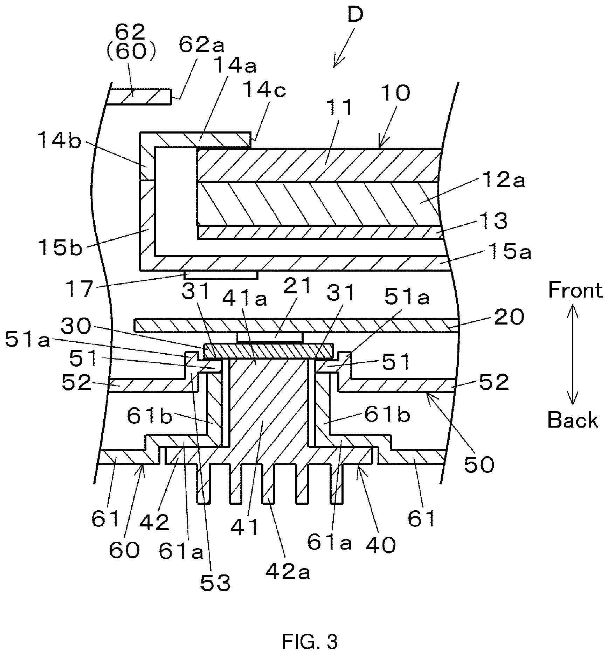

Next, a second embodiment according to the present invention will be described with reference to Fig. 3, but same reference numerals are used for the same or corresponding parts as in the first embodiment, and a detailed description thereof will be omitted. In the second embodiment, a configuration is provided in which the heat conducting member 30 abuts against the control unit mounted on the back side of the wiring board 20 instead of the bottom surface 15a of the rear frame 15.

In Fig. 3, the reference numeral 21 indicates the control unit serving as a heating electronic component mounted on the back side of the wiring board 20. It is noted that the display means 10, the heat conducting member 30, the heat dissipation member 40, etc. in the second embodiment have the same configurations and the same functions as those employed in the first embodiment. Moreover, in the case of the second embodiment, unlike the case of the first embodiment, the heat conducting member 30 and the case member 50 are arranged on the back side of the wiring board 20.

Also, the heat conducting member 30 in the second embodiment transfers heat emitted by the control unit 21 during an operation of the control unit 21 to the heat dissipation member 40, the case member 50, similarly to the first embodiment, employs a configuration in which the case member 50 includes an enclosure part 51 for enclosing the upper part 41a of the heat dissipation part 41 which is at least part of the heat dissipation member 40, and the enclosure part 51, similarly to the first embodiment, employs a configuration in which the enclosure part 51 encloses the upper part 41a of the heat dissipation part 41 such that the enclosure part 51 abuts against the non-contact part 31 of the heat conducting member 30 which is not in contact with the heat dissipation member 40.

At this time, since the non-contact part 31 of the heat conducting member 30 is sandwiched between the control unit 21 and the enclosure part 51 (that is, the non-contact part 31 is supported from the back side by the enclosure part 51), the heat conducting member 30 can be prevented from being positionally displaced in the left-right direction. Furthermore, since the wall part 51a is provided in the outer edge portion of the enclosure part 51 to cover the side of the heat conducting member 30, it is advantageous that the positional displacement in the left-right direction of the heat conducting member 30 can be suppressed more reliably.

Therefore, according to the second embodiment, the control unit 21 serving as a heating electronic component, the heat conducting member 30 for transferring the heat emitted by the control unit 21 to the heat dissipation member 40, and the case member 50 including the enclosure part 51 for enclosing the upper part 41a of the heat dissipation part 41 which is at least part of the heat dissipation member 40 are provided, and the enclosure part 51 encloses the upper part 41a of the heat dissipation part 41 such that the enclosure part 51 abuts against the non-contact part 31 of the heat conducting member 30 which is not in contact with the heat dissipation member 40. As a result, the positional displacement (in the left-right direction) of the heat conducting member 30 is suppressed since the non-contact part 31 is sandwiched between the control unit 21 and the enclosure part 51, and the same operation and effect as the first embodiment can be achieved.

It is noted that the present invention is not limited in any way to the above embodiments and the drawings. Modifications (including deletion of constituent elements) may be appropriately added to the embodiments and the drawings as long as the gist of the present invention is not changed.

For example, in each of the embodiments described above, an example in which the display means 10 is a liquid crystal display panel has been described, however, the display means 10 may be a pointer-type display unit including, as main components, a pointer and a display board provided with a translucent measurement value display unit made up of a graduation scale, etc. indicated by the pointer although being not illustrated in detail here. In this case, for example, the pointer is coupled to a rotating shaft of a motor (pointer driving means) mounted on the wiring board 20 to drive the pointer, and a light emitting element (heating electronic component) for illuminating the measurement value display unit from the back side is mounted on the front side of the wiring board 20.

Also, similarly to each of the embodiments described above, a configuration may be provided in which the heat conducting member 30 for transferring heat emitted by the light emitting element (heating electronic component) to the heat dissipation member 40 (via the wiring board 20), and the case member 50 which includes the enclosure part 51 for enclosing at least part of the heat dissipation member 40 (for example, the upper part 41a) are provided, and the enclosure part 51 encloses the upper part 41a such that the enclosure part 51 abuts against the non-contact part 31. Furthermore, in such a case, if necessary, the wiring board 20 may be replaced with a thermally conductive aluminum substrate formed of aluminum or the like.

### DESCRIPTION OF REFERENCE NUMERALS

- 10: Display means
- 11: Display element
- 11a: Display unit
- 12: Illumination means
- 12b: Light source (heating electronic component)
- 14: Front frame
- 15: Rear frame
- 16: Frame body
- 20: Wiring board
- 21: Control unit (heating electronic component)
- 30: Heat conducting member
- 31: Non-contact part
- 40: Heat dissipation member
- 41: Heat dissipation part
- 41a: Upper part
- 42: Flat plate part
- 42a: Fin
- 50: Case member
- 51: Enclosure part
- 51a: Wall part
- 60: Housing
- 61: Bottom wall part
- 61b: Frame-shaped part

## Claims

1. A heat dissipation structure comprising:
a heating electronic component;
a heat conducting member for transferring heat emitted by the heating electronic component to a heat dissipation member; and
a case member including an enclosure part for enclosing at least part of the heat dissipation member, wherein
the enclosure part encloses the at least part of the heat dissipation member such that the enclosure part abuts against a non-contact part of the heat conducting member not in contact with the heat dissipation member.

2. A heat dissipation structure comprising:
a display means including a display element equipped with a display unit for displaying prescribed information, a light source serving as a heating electronic component for supplying illumination light to the display element, and a conductive frame body for housing the display element and the light source;
a heat conducting member for transferring heat emitted by the light source from the conductive frame body to a heat dissipation member; and
a case member including an enclosure part for enclosing at least part of the heat dissipation member, wherein
the enclosure part encloses the at least part of the heat dissipation member such that the enclosure part abuts against a non-contact part of the heat conducting member not in contact with the heat dissipation member.

3. The heat dissipation structure according to claim 1 or claim 2, wherein the enclosure part includes a wall part covering a side of the heat conducting member.
